(19) **Europäisches Patentamt**

**European Patent Office**

**Office européen des brevets**

(11) **EP 0 921 633 B1**

(12) **FASCICULE DE BREVET EUROPEEN**

(45) Date de publication et mention
de la délivrance du brevet:
**21.05.2003 Bulletin 2003/21**

(51) Int Cl.⁷: **H03D 7/14**, H01G 7/00

(21) Numéro de dépôt: **98402920.7**

(22) Date de dépôt: **24.11.1998**

(54) **Translateur de fréquence perfectionné à faible consommation**

Verbesserter Frequenzverschieber mit geringem Stromverbrauch

Improved frequency shifter with low power dissipation

(84) Etats contractants désignés:
**DE FI FR GB SE**

(30) Priorité: **04.12.1997 FR 9715311**
**14.09.1998 FR 9811426**

(43) Date de publication de la demande:
**09.06.1999 Bulletin 1999/23**

(73) Titulaire: **THALES SYSTEMES AEROPORTES
S.A.
78990 Elancourt (FR)**

(72) Inventeurs:
- **Nicole, Pierre**
  **F-92210 Saint Cloud (FR)**
- **Bildstein, Paul**
  **F- 91370 Verrieres le Buisson (FR)**
- **Sangouard, Patrick**
  **F-94350 Villiers sur Marne (FR)**
- **Bazin, Gaelle**
  **F-94300 Vincennes (FR)**

(74) Mandataire: **Plaçais, Jean-Yves**
**Cabinet Netter,
36, avenue Hoche
75008 Paris (FR)**

(56) Documents cités:
**EP-A- 0 759 628**      **DE-A- 2 047 909**
**DE-A- 3 824 695**      **GB-A- 2 282 287**
**US-A- 4 699 006**      **US-A- 5 126 812**

- **PATENT ABSTRACTS OF JAPAN vol. 008, no.
  025 (E-225), 2 février 1984 & JP 58 187005 A
  (NIPPON GAKKI SEIZO KK), 1 novembre 1983**
- **PACHE D ET AL: "AN IMPROVED 3V 2GHZ
  BICMOS IMAGE REJECT MIXER IC"
  PROCEEDINGS OF THE CUSTOM INTEGRATED
  CIRCUITS CONFERENCE, SANTA CLARA, MAY
  1 - 4, 1995, no. CONF. 17, 1 mai 1995, pages 95-98,
  XP000536773 INSTITUTE OF ELECTRICAL AND
  ELECTRONICS ENGINEERS**

**Description**

L'invention, définie dans la revendication concerne les dispositifs électroniques à effet fréquentiel.

On sait changer la fréquence d'un signal en utilisant un élément non linéaire, auquel sont appliqués le signal de base F1 et un signal modulant f2. Agissant en mélangeur ou multiplieur, l'élément non linéaire fournit des produits de modulation de la forme (p*F1) + (q*f2), où p et q sont deux entiers positifs ou négatifs. On extrait par filtrage le produit de modulation désiré. Bien qu'ils réalisent une multiplication, ces dispositifs sont parfois appelés "translateurs de fréquence", puisqu'ils permettent d'obtenir, notamment, F1 + f2.

L'invention concerne plus particulièrement les translateurs de fréquence classiques qui fournissent directement l'addition ou translation F1 + f2, par multiplication, mais sans faire appel à un filtrage.

Pour réaliser de tels translateurs de fréquence classiques, on peut utiliser une technique dite à "retard variable", lequel retard est agencé pour correspondre à un déphasage croissant linéairement avec le temps. On utilise le fait que la fréquence étant la dérivée de la phase, au facteur $1/2\pi$ près, le signal de sortie possède un supplément de fréquence. Ce retard variable peut être réalisé sous forme analogique ou sous forme numérique. Toutefois, ces techniques dites "serrodynes" utilisées actuellement sont assez difficiles à mettre en oeuvre sur le plan matériel.

Par ailleurs, ces techniques font appel à des composants dont l'encombrement est relativement important.

La présente invention a donc pour objet de fournir une solution analogique qui ne présente pas tout ou partie des inconvénients précités.

L'un des buts de l'invention est de fournir un translateur de fréquence qui possède une très bonne réjection des fréquences parasites.

Un autre but de l'invention est de fournir un translateur de fréquence qui soit de très faible consommation, en particulier pour des applications mobiles.

L'invention a encore pour but de fournir un dispositif capable de fonctionner, notamment, en large bande, toutes les fréquences qui constituent un signal donné restant simultanément translatées de la même quantité.

Le dispositif dont il s'agit comprend de façon connue deux multiplieurs propres à recevoir un même signal de haute fréquence sur des premières entrées en quadrature l'une par rapport à l'autre, et un même signal de basse fréquence sur des secondes entrées également en quadrature l'une par rapport à l'autre, ainsi qu'un sommateur des sorties de ces multiplieurs.

Ce dispositif selon l'invention est original en ce que chacun des multiplieurs comprend un couple d'éléments à capacité variable de façon commandée, conjointe et en sens inverse, montés en parallèle, et en ce que les sorties respectives des deux éléments de chaque couple sont combinées additivement, compte-tenu de leur opposition de phase, pour former les sorties des deux multiplieurs. Un tel dispositif est capable d'un effet fréquentiel, à savoir la translation de tout le signal entrant de haute fréquence par le signal local de basse fréquence.

Dans un mode de réalisation préférentiel, chaque élément d'un couple est défini par un varactor (ou diode varicap polarisée), les deux varactors d'un couple étant montés en parallèle à partir d'un point commun et polarisés en inverse.

Dans ce mode de réalisation préférentiel, il est particulièrement avantageux, bien que l'on puisse procéder différemment, que la première et la seconde entrée de chaque multiplieur arrivent sur le point commun des deux varactors, par des liaisons séparées à découplage.

Dans un autre mode de réalisation, les couples d'éléments sont réalisés à l'aide d'un dispositif micro-mécanique. Plus précisément, chaque couple d'éléments est défini par:

- un premier support muni, d'une part, de deux pistes conductrices haute fréquence (HF) placées symétriquement de part et d'autre d'un premier plan de symétrie et présentant chacune une sortie, et d'autre part, deux pistes conductrices basse fréquence (BF) alimentées séparément par la seconde entrée et placées symétriquement de part et d'autre du premier plan de symétrie;
- un second support auquel est suspendue à rotation autour d'un axe une membrane subdivisée en deux demi-parties, de part et d'autre d'un second plan de symétrie comprenant l'axe, et portant, d'une part, deux pistes conductrices HF reliées à la première entrée et placées symétriquement de part et d'autre du second plan de symétrie, et d'autre part, deux pistes conductrices BF reliées à la masse et placées symétriquement de part et d'autre du second plan de symétrie.

Les premier et second supports sont solidarisés l'un à l'autre de telle sorte que les premier et second plans de symétrie sont sensiblement confondus et que les pistes HF, respectivement BF, du premier support sont superposées aux pistes HF, respectivement BF, du second support.

Ici, un élément de couple est formé, d'une part, d'une demi-membrane munie de sa piste HF et de sa piste BF et, d'autre part, de la piste HF et la piste BF qui leurs correspondent sur le premier support.

Les entrées haute fréquence et basse fréquence sont ici totalement découplées.

Avantageusement, la membrane, qui est réalisée de préférence par gravure de type RIE (Reactive Ion Etching), peut comporter un ou plusieurs trous traversant de dimensions choisies, de manière à réduire l'amortissement des flux d'air dans la structure.

De façon particulièrement avantageuse, le couple d'éléments micro-mécanique est réalisé dans des matériaux de type verre/Silicium. Plus précisément, le premier support est de préférence formé d'un pavé en verre, et le second support est de préférence formé d'un empilement d'une couche d'oxyde de Silicium ($SiO_2$) intercalée entre un substrat inférieur en Silicium et une couche supérieure en Silicium, dans laquelle est formée la membrane.

Il peut être également particulièrement avantageux, pour des raisons de filtrage, notamment dans le mode de réalisation avec varactors, que chaque multiplieur comprenne une inductance entre chaque élément à capacité variable et son point commun.

Selon d'autres caractéristiques de l'invention, avantageuses mais optionnelles, et utilisables indépendamment les unes des autres, aussi bien qu'en combinaison, en totalité comme en partie:

- les déphasages en haute fréquence peuvent être réalisés par des lignes à retard, en particulier en câble coaxial, notamment dans les applications à bande étroite;
- les déphasages en basse fréquence peuvent être réalisés, notamment dans les applications à bande étroite, par une ou plusieurs cellules de type "R-C" formant différentiateur sur une voie, et une ou plusieurs cellules de type "C-R" formant intégrateur sur l'autre voie, l'ensemble étant agencé pour fournir la quadrature de phase d'une voie à l'autre;
- les déphasages, notamment dans les applications en bande large ou très large, sont réalisés à l'aide de réseaux à différence de phase, en haute fréquence ou en basse fréquence;
- les liaisons séparées à découplage sont rapportées à une tension de référence de la polarisation.

D'autres caractéristiques et avantages de l'invention apparaîtront à l'examen de la description détaillée ci-après, ainsi que des dessins annexés, sur lesquels :

- la figure 1 est un schéma de principe général d'un translateur de fréquence;

- la figure 2 est un schéma d'un mode de réalisation d'un dispositif translateur de fréquence selon l'invention équipé de couples d'éléments à capacité variable de façon commandée d'un premier type;

- la figure 3 est un schéma du translateur de fréquence de la figure 2 détaillant un mode de réalisation des modules de déphasage;

- la figure 4 illustre une variante de multiplieur applicable aux dispositifs des figures 2 et 3;

- la figure 5 illustre, de façon très schématique et en perspective, un couple d'éléments à capacité variable de façon commandée d'un second type (les échelles n'étant pas respectées);

- la figure 6 est une vue en coupe transversale selon l'axe VI-VI de la figure 5;

- la figure 7 illustre, de façon très schématique et en perspective, la membrane utilisée dans le couple d'éléments à capacité variable de façon commandée, du second type, des figures 5 et 6;

- la figure 8 illustre de façon schématique les capacités formées par la superposition des pistes HF et BF portées par la membrane et le premier support;

- les figures 9A et 9B détaillent un mode de réalisation des pistes HF et BF portées respectivement par la membrane et le premier support;

- la figure 10 est une schéma illustrant le mécanisme de variation de capacité du couple d'éléments du second type illustré sur les figures 5 à 9; et

- la figure 11 est un schéma d'un mode de réalisation d'un dispositif translateur de fréquence selon l'invention équipé de couples d'éléments à capacité variable de façon commandée du second type.

Les dessins annexés sont pour l'essentiel de caractère certain. En conséquence, ils pourront non seulement permettre de mieux faire comprendre la description détaillée, mais aussi contribuer à la définition de l'invention, le cas échéant.

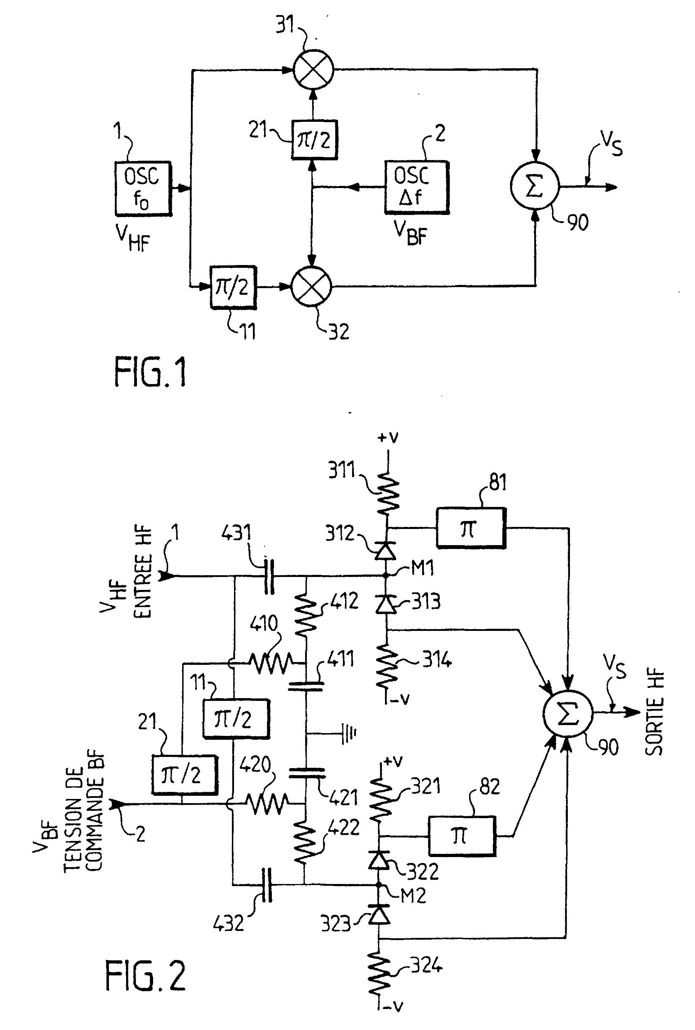

Sur la figure 1, les références 1 et 2 désignent respectivement des sources de haute fréquence $f_0$ et de basse fréquence $\Delta f$, présentées ici comme des oscillateurs. La sortie de la source haute fréquence 1 est appliquée directement à une première entrée d'un multiplieur 31, et indirectement via un déphaseur de $\pi/2$ (quadrature avance) 11 à une première entrée d'un second multiplieur 32.

De même, la sortie de la source basse fréquence 2 est appliquée directement à une seconde entrée du second multiplieur 32, tandis qu'elle est appliquée indirectement via un déphaseur de $\pi/2$ (quadrature avance) 21 à une seconde entrée du premier multiplieur 31. Les sorties des deux multiplieurs 31 et 32 sont appliquées à un sommateur 90.

Ce schéma est à considérer comme connu, au moins en son principe. Il fournit un signal de la forme :

$$S = A.\ \sin\ (2\Pi.(f_0 + \Delta f).t)$$

La présente invention propose un mode de réalisation original d'un tel schéma, qui présente de nombreux avantages, dont celui de pouvoir travailler en fréquences très élevées, avec une très faible consommation, en large bande pour l'entrée (source) haute fréquence, tout en réalisant une véritable translation de toutes les hautes fréquences d'entrée, telle que définie en introduction, avec une très bonne réjection des fréquences parasites.

Un mode de réalisation complet d'un translateur de fréquence permettant tout cela est illustré sur la figure 2. L'entrée (source) de haute fréquence (HF) est illustrée en 1, tandis que l'entrée (source) de basse fréquence (BF) est illustrée en 2, il s'agit ici, plus précisément, d'une tension de commande basse fréquence.

Le premier multiplieur équivalent à celui référencé 31 sur la figure 1 comporte un couple d'éléments à capacité variable de façon commandée, conjointe et en sens inverse, et présentant un point commun M1 connecté à la source de haute fréquence 1 via un condensateur 431. Chaque élément est ici formé d'une diode varicap polarisée en inverse ou varactor 312 ou 313.

La sortie du premier varactor 312, monté en inverse, est reliée d'une part à un module de déphasage 81, ici de $\pi$, et d'autre part, à un première borne placée à une tension +V via une résistance 311. La sortie du déphaseur 81 formant première sortie du premier multiplieur 31 est connectée à la première entrée d'un sommateur 90. La sortie du second varactor 313, monté en inverse, formant seconde sortie du premier multiplieur 31, est reliée d'une part directement à une seconde entrée du sommateur 90, et d'autre part, à une seconde borne placée à une tension -V via une résistance 314. Les deux varactors 312 et 313 sont ainsi montés en parallèle relativement au point commun M1 et au sommateur 90.

Le point commun M1 est également relié, dans ce mode de réalisation, à la source de basse fréquence 2 via, dans cet ordre, une première résistance 412, une seconde résistance 410 et un déphaseur de $\pi/2$ 21 équivalent à celui illustré sur la figure 1, le point de liaison entre les deux résistances 412 et 410 étant relié à la masse via un condensateur 411. Dans le domaine des hyperfréquences, un tel déphaseur de $\pi/2$ est parfois directement réalisé à l'aide d'un coupleur de structure appropriée, comme par exemple un coupleur hybride, bien connu de l'homme de l'art.

Les valeurs de la résistance 412 (R') et des capacités des condensateurs 431 (Ce) et 411 (C'), qui assurent les découplages des signaux HF et BF, sont choisies de sorte que chacun de ces signaux ne perturbe pas l'autre en "remontant" dans la partie de circuit qui lui est propre. Ce (431) est donc choisie de sorte que le résidu de la basse fréquence BF soit atténué au maximum au niveau de l'entrée haute fréquence HF, tandis que C' (411) et R' (412) sont choisies de sorte que le résidu de la haute fréquence HF soit atténué au maximum au niveau de l'entrée basse fréquence BF. En d'autres termes, Ce sert de filtre coupant la basse fréquence tout en autorisant le passage de la haute fréquence, tandis que C' et R' servent de filtre coupant la haute fréquence tout en autorisant le passage de la basse fréquence. Le dispositif n'est donc pas limité aux filtres HF et BF illustrés sur les figures.

De même, le second multiplieur équivalent à celui référencé 32 sur la figure 1 comporte un couple d'éléments à capacité variable de façon commandée, conjointe et en sens inverse, et présentant un point commun M2 connecté à la source de haute fréquence 1 via, dans cet ordre, un condensateur 432 et un module de déphasage de $\pi/2$ 11 équivalent à celui illustré sur la figure 1. Chaque élément est ici également formé d'une diode varicap polarisée en inverse ou varactor 322 ou 323.

La sortie du premier varactor 322, monté en inverse, est reliée d'une part à un module de déphasage 82, ici de $\pi$, et d'autre part, à un première borne placée à une tension +V via une résistance 321. La sortie du déphaseur 82 formant première sortie du second multiplieur 32 est connectée à la troisième entrée du sommateur 90. La sortie du second varactor 323, monté en inverse, formant seconde sortie du second multiplieur 32, est reliée d'une part directement à une quatrième entrée du sommateur 90, et d'autre part, à une seconde borne placée à une tension -V via une résistance 324. Les deux varactors 322 et 323 sont ainsi montés en parallèle relativement au point commun M2 et au sommateur 90.

Le point commun M2 est également relié à la source de basse fréquence 2 via, dans cet ordre, une première résistance 422 et une seconde résistance 420, le point de liaison entre les deux résistances 422 et 420 étant relié à la masse via un condensateur 421.

Les deux condensateurs 411 et 421 ramenés à la masse, sont ainsi reliés au point milieu M entre les deux tensions d'alimentation +V et -V. Cette caractéristique est intéressante, mais non impérative.

La première entrée du premier multiplieur 31, qui l'alimente en haute fréquence, est donc en quadrature par rapport à la première entrée du second multiplieur 32, qui l'alimente avec le même signal de haute fréquence. De même, la seconde entrée du second multiplieur 32, qui l'alimente en basse fréquence, est en quadrature par rapport à la seconde entrée du premier multiplieur 31, qui l'alimente avec le même signal de basse fréquence.

Les multiplieurs 31 et 32 ainsi constitués comportent donc chacun deux sorties, en opposition de phase l'une par rapport à l'autre. Le sommateur 90 effectue alors la sommation de ces quatre sorties des multiplieurs de façon à fournir le signal de sortie Vs.

Pour les meilleurs résultats, les couples de varactors 312 et 313, respectivement 322 et 323, sont bien appariés, de préférence très bien appariés de façon à obtenir des taux de réjection des fréquences parasites élevés.

En modifiant le point de polarisation des deux varactors d'une paire (ou couple), le signal de basse fréquence issu de la source 2 augmente la capacité de l'un et diminue la capacité de l'autre.

Plus précisément, le montage décrit peut être considéré comme un pont capacitif équilibré à deux voies. C'est pourquoi, le pont étant équilibré, toute augmentation d'une des deux capacités se traduit par une diminution de l'autre. Dans une première approximation où la variation de capacité est supposée linéaire en fonction de la tension, les deux capacités vues par la source de haute fréquence 1 HF pour chaque multiplieur sont données par les formules suivantes:

$$* C_1 (V_{BF}) = C_0.(1-\alpha.V_{BF})$$

$$* C_2 (V_{BF}) = C_0 (1+\alpha.V_{BF})$$

avec $\alpha \neq 0$ (dans l'exemple illustré sur la figure 2, $\alpha < 0$), $C_0$ étant la capacité moyenne des diodes, $C_1$ désignant la capacité du varactor 312 ou 322 du premier 31 ou second 32 multiplieur, relié à la borne placée à la tension +V, et $C_2$ désignant la capacité du varactor 313 ou 323 du premier 31 ou second 32 multiplieur, relié à la borne placée à la tension - V.

On peut alors écrire le signal de sortie $Vi_S$ (i=31,32), pour la sommation des deux sorties d'un même multiplieur, en fonction du signal d'entrée haute fréquence $V_{HF}$ et du signal basse fréquence $V_{BF}$ de la manière indiquée ci-après.

$$Vi_S = V_{HF}.\left(\frac{j.\omega.R_0.C_2}{1+j.\omega.R_0.C_2} - \frac{j.\omega.R_0.C_1}{1+j.\omega.R_0.C_1}\right)$$

où $R_0$ est l'impédance vue par le signal de sortie de chaque sortie d'un multiplieur.

Cette expression peut, après développement puis simplification se transformer en :

$$Vi_S = j.\omega.R_0.C_0.\left(\frac{2.\alpha.V_{BF}}{(1+j.\omega.R_0.C_0.)^2 - (\alpha.V_{BF})^2.\left(\overline{j.\omega.R_0.C_0.}\right)^2}\right).V_{HF}$$

Lorsque la valeur $(\alpha.V_{BF})$ reste faible, typiquement jusqu'à une valeur d'environ 0,2, on peut prendre une approximation de l'expression ci-dessus (2) pour obtenir la formule suivante :

$$Vi_S = 2.\alpha.V_{BF}.\left(\frac{j.\omega.R_0.C_0}{1+j.\omega.R_0.C_0.)^2}\right).V_{HF}$$

où :

$$\alpha = \frac{\Delta C}{C.\Delta V_{BF}}$$

L'homme du métier appréciera que le signal de sortie d'un multiplieur $Vi_S$ (i désigne l'un ou l'autre des multiplieurs) est bien cette fois un produit du signal d'entrée haute fréquence $V_{HF}$ et de la tension de commande basse fréquence $V_{BF}$.

Dans un tel dispositif à diodes, les deux tensions HF ($V_{HF}$) et BF ($V_{BF}$) se superposent et font simultanément changer la valeur de la capacité instantanée de chaque diode. Il faut donc prévoir une seconde condition, en supplément de celle portant sur la valeur de ($\alpha.V_{BF}$), de façon à obtenir en sortie du multiplieur un spectre quasiment pur, c'est à dire ne comportant que peu d'harmoniques secondaires.

Cette seconde condition est donnée par la relation suivante: $V_{HF} \ll V_{BF}$. Typiquement on choisira de préférence un rapport $V_{HF}/V_{BF}$ compris entre environ 0,1 et 0,01, voire plus faible encore.

A partir de là, le montage illustré sur la figure 2, qui possède deux multiplieurs opérant de la même manière, mais avec des tensions de commande décalées de $\pi/2$ et opérant en sens inverse, fournira bien le résultat donné conformément au schéma de principe de la figure 1.

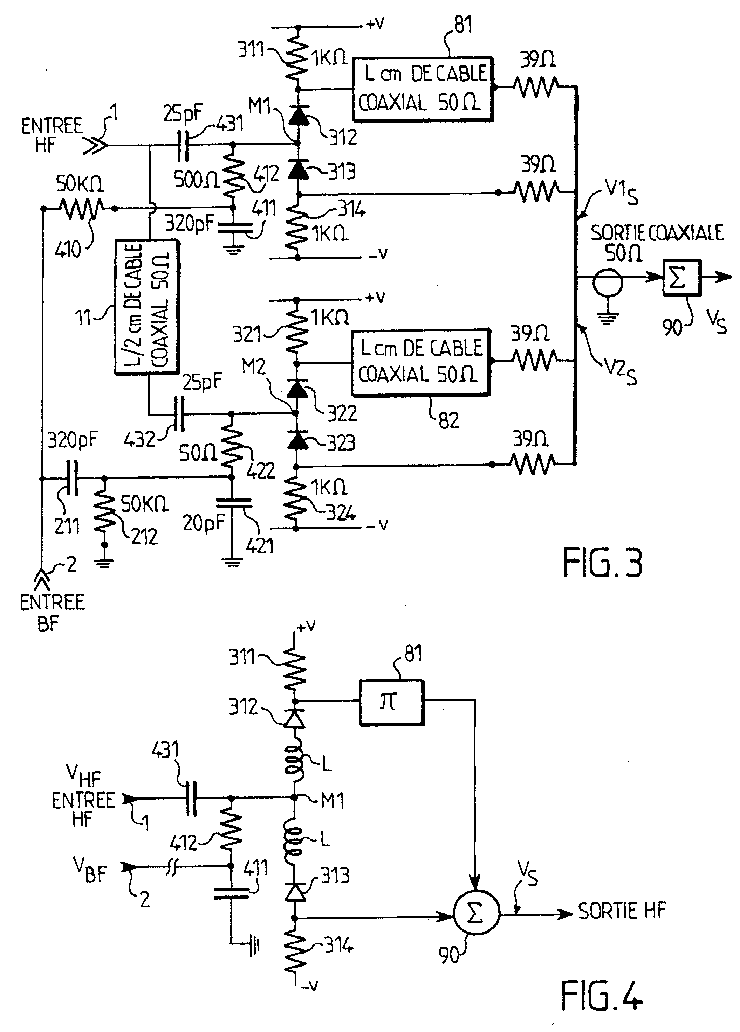

Les déphasages appliqués en haute fréquence, notamment par les déphaseurs 81, 82 et 11, peuvent être réalisés de différentes manières connues de l'homme du métier. On a illustré sur la figure 3 un mode de réalisation détaillé du translateur de fréquence de la figure 2, dans lequel certains des modules de déphasage sont, du fait des signaux hyperfréquences, réalisés par des lignes à retards, convenablement calibrées (par exemple pour les applications en bande étroite). C'est notamment le cas des déphaseurs $\pi$ 81 et 82 et du déphaseur $\pi/2$ 11.

Dans les applications en bande large, voire bande très large, on utilisera des déphaseurs $\pi/2$ à large bande ou très large bande, comme par exemple ceux réalisés à l'aide de réseaux à différences de phase. De tels réseaux sont notamment décrits dans les documents de S.D.BEDROSIAN "Normalized Design of 90° Phase-Difference Networks", IRE Transactions On Circuit Theory, juin 1960, p.128-136 et de D.K.WEAVER,Jr "Design of RC Wide-Band 90-Degree Phase-Difference Network", Proceedings of the IRE, avril 1954, P.671-676. Ils sont formés de deux quadripôles alimentés par un même signal d'entrée, et dont les sorties respectives sont soustraites de manière à fournir le déphasage de $\pi/2$.

Dans cet exemple de réalisation, les déphasages de $\pi$ 81 et 82 sont plus précisément obtenus à l'aidé de câbles coaxiaux, de préférence d'une impédance de 50 $\Omega$, d'une longueur L adaptée audit déphasage de $\pi$, tandis que le déphasage de $\pi/2$ 11 est plus précisément obtenu à l'aide d'un câble coaxial de même type (ici impédance de 50 $\Omega$ équivalente à l'impédance sur l'entrée haute fréquence), d'une longueur L/2 adaptée audit déphasage de $\pi/2$.

En basse fréquence et pour des signaux en bande étroite, la demanderesse a observé qu'il était préférable de faire non pas un unique déphasage de $\pi/2$ entre les deux secondes entrées basse fréquence des multiplieurs 31 et 32, comme illustré sur la figure 2, mais, mieux, deux déphasages de $\pi/4$ de sens opposés respectivement sur chaque seconde entrée de multiplieur.

A cet effet, il est possible d'utiliser le fait que des circuits de type C-R arrangés en différentiateurs produisent une avance de phase, tandis que des circuits de type R-C arrangés en intégrateurs produisent un retard de phase. Avec un ou plusieurs circuits du même type, on peut donc réaliser une avance de phase de $\pi/4$ sur l'une des voies, et un retard de phase de $\pi/4$ sur l'autre, ce qui revient à un décalage relatif en quadrature ($\pi/2$) entre les deux voies. En outre, une telle réalisation par circuit RC est parfaitement compatible avec le montage, dont elle peut de surcroît respecter les impédances.

Dans cet exemple, un déphasage de $-\pi/4$ est donc obtenu en utilisant, sur la voie connectant la seconde entrée du premier multiplieur 31 à la source de basse fréquence 2, le circuit R-C intégrateur formé de la résistance 410 et du condensateur 411, tandis qu'un déphasage de $+\pi/4$ est obtenu en utilisant, sur la voie connectant la seconde entrée du second multiplieur 32 à la source de basse fréquence 2, un circuit C-R différentiateur formé du condensateur 211 et de la résistance 212 d'environ 50 k$\Omega$ reliée à la masse.

Sur la figure 3, toutes les valeurs des composants sont données à titre d'exemple non limitatif. Ces valeurs constituent, ici, un compromis permettant d'obtenir une faible impédance vis à vis de la haute fréquence HF, qui est dans cette application d'environ 1,65 GHz, et une forte impédance devant 50 k$\Omega$ (impédance sur l'entrée basse fréquence) vis à vis de la basse fréquence BF, qui est dans cette application d'environ 10 kHz. Par ailleurs, le niveau de l'entrée haute fréquence HF est d'environ -10 dBm au maximum, tandis que le niveau de l'entrée basse fréquence BF est d'environ 500 mV crête à crête.

Toujours dans cet exemple, les varactors, qui pourront être ceux de la série 5082-3080 de la société Hewlett-Packard, sont polarisés en inverse sous des tensions d'environ +/-2,5 Volts.

Bien entendu, d'autres valeurs de composants pourront être utilisées selon les applications, et notamment selon les fréquences de travail haute et basse. Ainsi, l'entrée haute fréquence peut être une fréquence allant de quelques mégahertz à quelques dizaines de gigahertz, tandis que l'entrée basse fréquence peut être une fréquence allant de quelques hertz à quelques dizaines de kilohertz, typiquement 50 kHz. En général, les valeurs sont plutôt typiquement de quelques kilohertz, par exemple dans les applications de télécommunications avec les mobiles où l'influence des décalages Doppler doit être limitée. De même, suivant le type de varactor choisi, les tensions +V et -V pourront aller de +/-1 Volt à +/-10 Volts environ. Enfin, les résistances de couplage sont choisies notamment en fonction de la fréquence de coupure que l'on veut obtenir sur la tension de commande basse fréquence 2.

Afin d'améliorer le rapport signal de sortie sur signal d'entrée, du dispositif, lequel est réduit du fait de l'utilisation de modules RC ou CR, on peut, comme cela est illustré sur la figure 4, placer en série entre chaque diode et son point commun Mi une inductance L. La valeur de L est choisie de sorte que la condition $L.C_0.\omega^2=1$ soit vérifiée (avec $\omega=2\pi f$, f étant la fréquence HF, et $C_0$ étant la valeur utilisée dans les formules des capacités $C_1$ et $C_2$).

De la sorte, on peut obtenir un signal de sortie qui peut être jusqu'à deux fois plus fort (en amplitude) que la valeur qu'il présenterait sans inductance dans le dispositif. En d'autres termes, on peut gagner jusqu'à 6dB sur la perte d'insertion, ou plutôt de conversion. De plus, cette solution permet, en choisissant les valeurs R des résistances 311, 312, 321 et 322 égales à celle d'une résistance caractéristique $R_0$ vue sur la sortie d'un multiplieur (typiquement 50 Ω ou 75 Ω), de rendre le chemin de la haute fréquence HF 5 entièrement adapté.

Par ailleurs, les valeurs optimales des résistances R et $C_0$ étant ici liées par la relation $R.C_0.\omega\approx1$ (pour la HF), en prenant $R=R_0$, on peut en déduire la valeur de $C_0$, permettant ainsi de fixer directement le choix des diodes et de leur point de polarisation.

On peut noter que cette relation $R.C_0.\omega\simeq1$, permet d'obtenir, que le dispositif possède ou non des inductances, l'amplitude maximale du signal en sortie du dispositif.

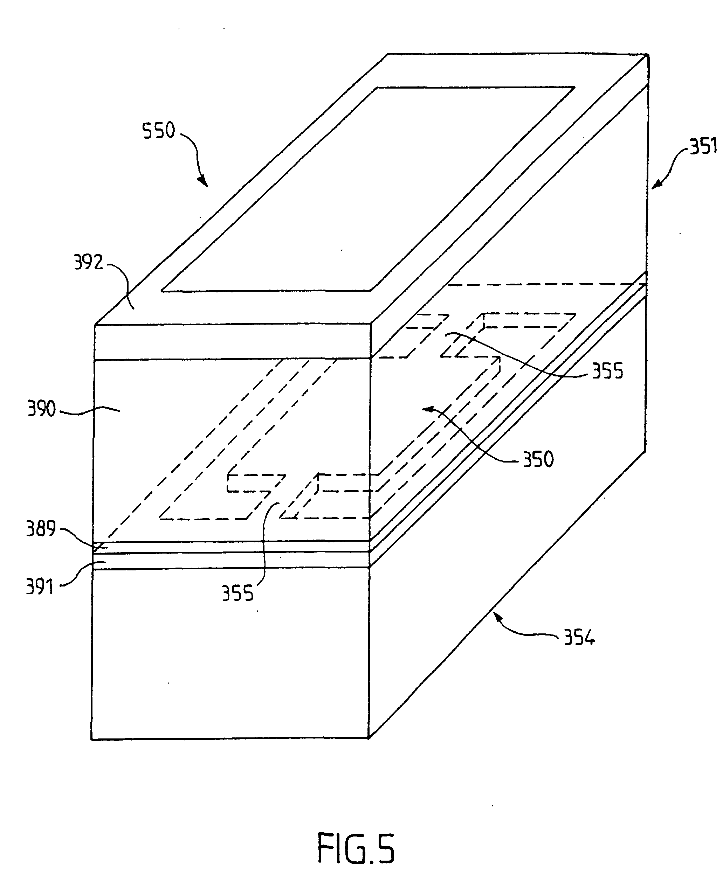

On se réfère maintenant aux figures 5 à 11 pour décrire un autre mode de réalisation des couples d'éléments à capacité variable de façon commandée. Ce mode utilise un dispositif micro-mécanique de très petites dimensions.

Les couples d'éléments (312, 313) et (322, 323) qui sont utilisés dans les multiplieurs 31 et 32 des translateurs de fréquence illustrés sur les figures 2 à 4 peuvent être remplacés par des couples d'un autre type.

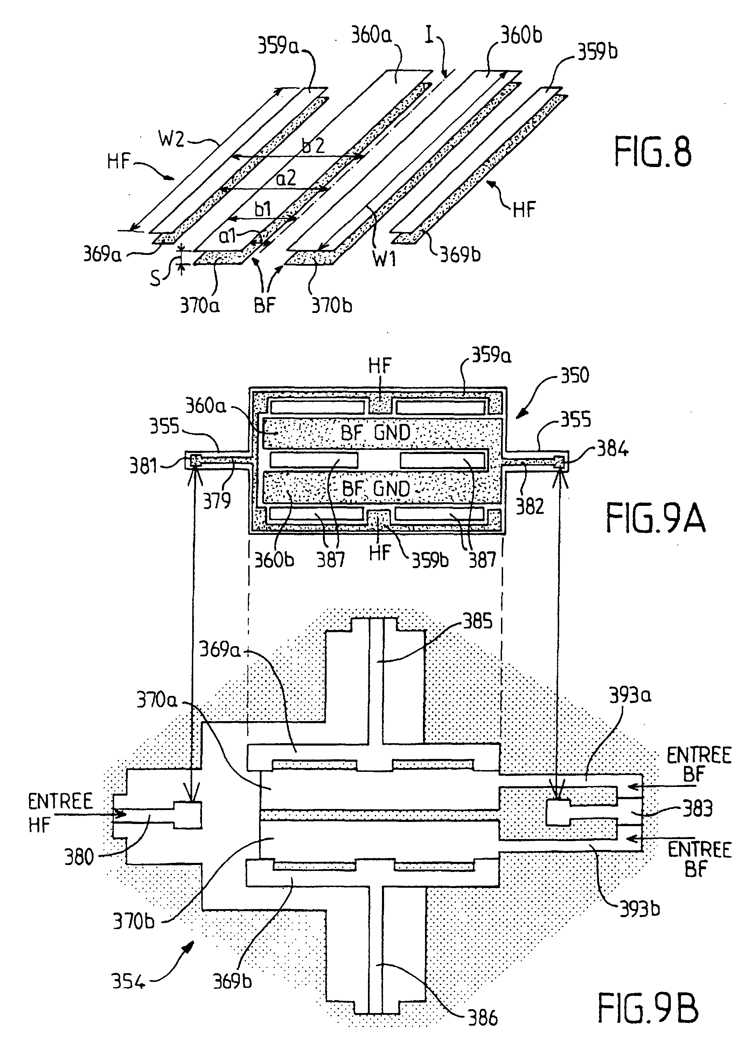

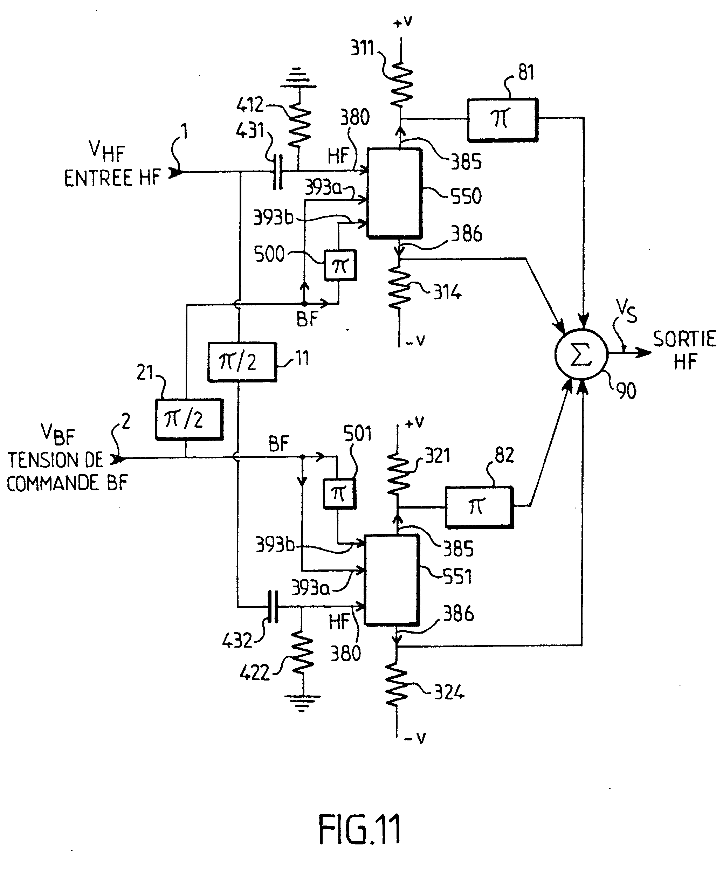

La figure 5 illustre, en perspective, un couple d'éléments à capacité variable, de façon commandée. Il s'agit d'un élément micro-mécanique 550 ou 551 (voir figure 11) comportant une membrane 350 (représentée en pointillé) solidarisée à un support 351 partiellement évidé. Cette membrane 350 porte sur une face 352, que l'on qualifiera ici d'"inférieure", des pistes conductrices sur lesquelles on reviendra plus loin, et qui forment en coopération avec d'autres pistes portées par 5 une face 353, que l'on qualifiera de "supérieure", d'un autre support 354, les capacités variables (voir figures 6 et 8).

Avantageusement, les deux supports 351 et 354 sont solidarisés l'un à l'autre d'une manière qui sera décrite plus loin.

La membrane 350 (voir figures 5 à 7) est un élément de très petites dimensions, typiquement quelques milliers de micromètres de longueur pour une largeur de l'ordre du millier de micromètres et une épaisseur de l'ordre de la dizaine de micromètres. Bien entendu, ces dimensions sont données à titre d'exemple et peuvent varier selon les besoins.

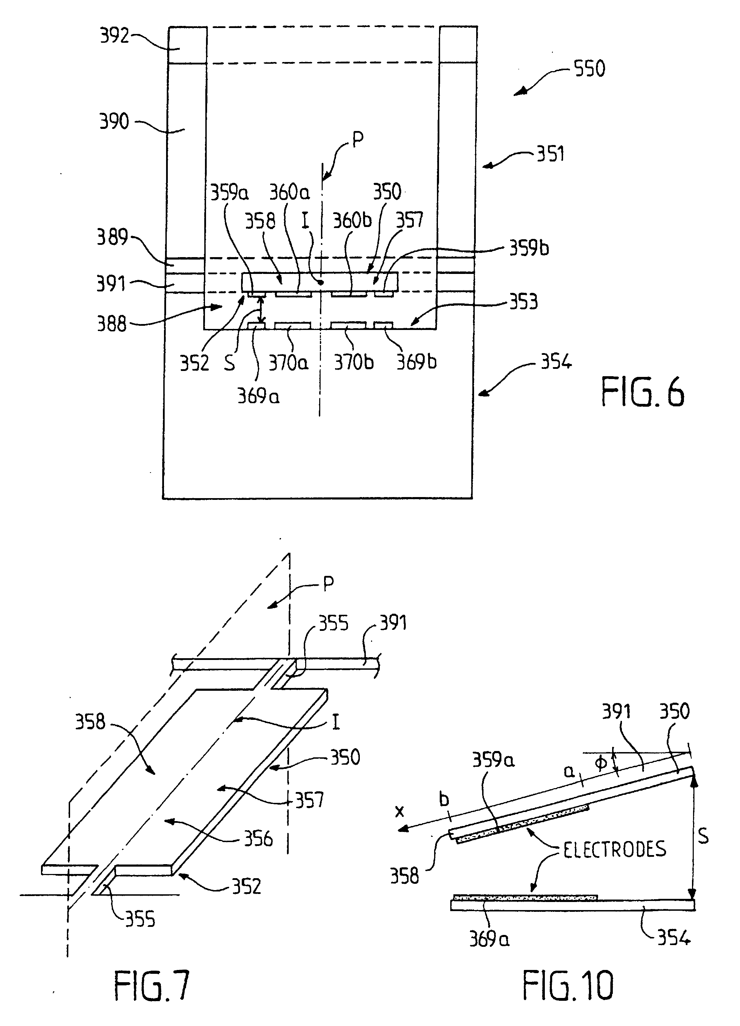

Comme cela est mieux illustré sur la figure 7, la membrane 350 est un élément monté à rotation autour d'un axe I, grâce à des bras axiaux 355 de torsion, opposés l'un à l'autre, et qui prolongent une partie centrale 356, ici de forme rectangulaire, dont la face inférieure 352 supporte les pistes. Les bras de torsion 355 sont placés sensiblement au milieu de chaque petit côté du rectangle délimitant la partie centrale 356, si bien que l'axe de rotation I coïncide sensiblement avec l'axe médian longitudinal de la membrane 350. La membrane 350 (sa partie centrale 356 et ses bras de torsion 355) peut être subdivisée en deux parties 357 et 358, ici sensiblement identiques, et placées symétriquement de part et d'autre d'un plan P perpendiculaire à la face 352 et contenant l'axe de rotation I.

Comme cela est illustré sur la figure 6, chaque demi-partie 357 ou 358 de la membrane 350 porte une piste conductrice haute fréquence HF 359a ou 359b et une piste basse fréquence BF 360a ou 360b. De préférence, les pistes HF 359a et 359b sont placées de façon symétrique de part et d'autre du plan P. Il en va de même, de préférence, des pistes basse fréquence 360a et 360b, qui sont placées de façon symétrique de part et d'autre de ce plan P. Par ailleurs, les pistes basse fréquence BF 360a et 360b sont, de préférence, encadrées par les pistes haute fréquence HF 359a et 359b, ce qui veut dire que les pistes BF 360a et 360b sont plus proches de l'axe I que les pistes HF 359a et 359b. Bien entendu, on pourrait procéder différemment, les pistes basse fréquence encadrant alors les pistes haute fréquence, ces dernières étant par conséquent plus proches de l'axe I que ne le sont les pistes basse fréquence.

Comme indiqué précédemment, pour former des capacités, à chaque piste de la membrane 350 correspond, respectivement, une piste placée sur la face supérieure 352 du support 354. Ainsi, à la piste HF 359a correspond une piste HF 369a, à la piste BF 360a correspond une piste BF 370a, à la piste BF 360b correspond une piste BF 370b et à la piste HF fréquence 359b correspond une piste HF 369b. On entend ici par "correspondre" le fait que les pistes appartenant à deux supports différents 351 et 354 sont, au repos, sensiblement parallèles et superposées l'une à l'autre, et présentent une forme générale sensiblement identique (voir figures 8, 9A et 9B), aussi bien dans la direction axiale (parallèle à l'axe I) que dans une direction transversale (perpendiculaire à l'axe I). De la sorte, les pistes qui se correspondent, par exemple 359a et 369a, forment une capacité.

Pour faire varier la valeur d'une capacité ainsi formée, il suffit de faire varier la distance s qui sépare deux pistes minces qui se correspondent. Pour ce faire, il suffit de provoquer la rotation (ou torsion) de la membrane 350 autour de l'axe I. En effet, dans cette situation, qui est mieux illustrée sur la figure 10, une rotation de la membrane 350 d'un angle $\phi$ va entraîner le rapprochement des pistes qui se correspondent (ici 359a et 369a), et l'écartement des pistes placées symétriquement de l'autre côté du plan P (ici 359b et 369b). A un rapprochement d d'un couple de pistes haute fréquence va correspondre un écartement d'une hauteur d des pistes haute fréquence opposées par rapport au plan P. On réalise ainsi un couple d'éléments à capacité variable, les capacités de chaque élément variant de façon opposée, l'une augmentant lorsque l'autre décroît, et réciproquement.

Pour provoquer l'entraînement en rotation de la membrane 350, on utilise une tension de commande VBF. Comme indiqué précédemment lors de la description du premier mode de réalisation à varactors, la tension de commande VBF est celle délivrée par la voie basse fréquence. Cette tension VBF est injectée dans le couple d'éléments micro-mécanique par ses pistes basse fréquence.

Dans le mode de réalisation illustré sur les figures 9A et 9B, chaque piste 370a ou 370b du support 354 comporte une extension 393a ou 393b qui est reliée à la seconde entrée du dispositif (voir figure 11) de manière à être alimentée en basse fréquence VBF. Ces deux extensions 393a et 393b sont alimentées indépendamment l'une de l'autre par des signaux basse fréquence déphasés de $\pi$ (180°).

Ce déphasage est obtenu, par exemple, en dédoublant en deux voies, l'une étant déphasée de $\pi$ par rapport à l'autre, d'une part, la ligne d'alimentation basse fréquence (seconde entrée) qui alimente le multiplieur de la partie "supérieure" via le déphaseur de $\pi/2$ 21 et, d'autre part, la ligne d'alimentation basse fréquence (seconde entrée) qui alimente directement le multiplieur de la partie "inférieure". Le déphasage de $\pi$ d'une voie par rapport à l'autre est obtenu, de préférence, par un inverseur 500 ou 501.

La haute fréquence est, de préférence, transmise à la structure micro-mécanique par sa membrane 350. Pour ce faire, les deux pistes HF 359a et 359b sont reliées par l'une de leurs extrémités à la première entrée, par le biais d'une extension 379 portée par l'un des bras de torsion 355.

De préférence, l'alimentation de l'extension 379 des pistes haute fréquence de la membrane 350 s'effectue via le support 354, lequel comporte à cet effet une piste d'alimentation haute fréquence 380. La liaison entre cette piste d'alimentation haute fréquence 380 et l'extension 379 des pistes haute fréquence de la membrane 350 s'effectue à l'aide d'un plot conducteur, ou encore d'une électrode de contact, par exemple formée sur la membrane en 381. En variante, ce plot de contact ou électrode peut être formé sur la piste d'alimentation HF 380. Comme illustré sur la figure 11, la piste d'alimentation HF 380 est reliée à la première entrée HF 1 via le condensateur 431 ou 432.

De préférence, les pistes basse fréquence 360a et 360b portées par la membrane 350 sont reliées l'une à l'autre par l'une de leurs extrémités, cette liaison se prolongeant par une extension 382 portée par le bras radial 355 qui est opposé au bras radial portant l'extension haute fréquence 379. Dans l'exemple illustré sur les figures 9A et 9B, cette extension basse fréquence 382 est reliée à la masse du dispositif via le support 354, lequel comporte à cet effet une piste de raccordement à la masse 383. La liaison entre l'extension basse fréquence 382 de la membrane 350 et le support 354 s'effectue, comme pour la haute fréquence, par le biais d'un plot de contact 384 ou d'une électrode, qui est par exemple portée par la membrane (comme illustré sur la figure), mais en variante elle pourrait être portée par la piste de raccordement à la masse 383.

Il est important de noter que dans ce mode de réalisation l'entrée haute fréquence et l'entrée basse fréquence de chaque multiplieur sont découplées. C'est la raison pour laquelle le dispositif translateur de fréquence illustré sur la figure 11 est simplifié par rapport à celui illustré sur la figure 2. Du fait du découplage, les résistances 412 et 422 sont désormais reliées à la masse, respectivement. Par ailleurs, il n'est pas indispensable (comme illustré sur la figure 11) de prévoir, sur les voies déphasées d'alimentation en basse fréquence, une cellule de type R-C du type de celles illustrées sur les figures 2 à 4, et portant les références 410, 411 et 420, 421. Enfin, les inductances L illustrées sur la figure 4, et placées entre le point d'alimentation en haute fréquence 380 et les pistes haute fréquence 359a et 359b, peuvent être utilisées pour effectuer un filtrage, moyennant une adaptation des pistes de la figure 9A.

Dans cet exemple, le signal haute fréquence entre par les pistes haute fréquence de la membrane 350, puis est transmis par couplage capacitif aux pistes haute fréquence 369a et 369b portées par le support 354. Les signaux haute fréquence sont alors extraits des pistes haute fréquence du support 354 par des sorties 385 et 386 réalisées sous la forme d'extension (ici perpendiculaires) desdites pistes. Ces deux sorties alimentent le sommateur 90, l'une 386 étant directement reliée à celui-ci, l'autre 385 subissant un déphasage par l'un des moyens 81 ou 82 décrit précédemment en référence aux figures 2 à 4.

Dans ce mode de réalisation de type micro-mécanique, il est particulièrement avantageux que les déphasages en haute fréquence 11, 81 et 82 soient réalisés par des lignes à retard, et plus particulièrement en technologie de ligne imprimée sur substrat. Le substrat pourra être de type circuit imprimé classique, par exemple en époxy, ou bien de type ligne microstrip sur silicium.

Les dimensions et formes des différentes pistes, les dimensions de la membrane et l'écart s entre les pistes portées par la membrane et par le support 354 dépendent, notamment, des signaux d'entrée haute fréquence VHF et basse fréquence VBF du dispositif et des signaux de sortie souhaités.

Dans une telle structure, on peut déterminer l'angle d'équilibre $\phi$ qui est atteint lorsque l'on applique une tension de commande basse fréquence V=VBF inférieure à une tension limite. On détermine également la capacité formée par les couples de pistes qui se correspondent. Cet équilibre est atteint lorsque le moment de la force élastique de torsion de la membrane compense intégralement le moment de la force d'attraction électrostatique. Dans l'hypothèse où l'angle φ de rotation de la membrane 350 reste petit, l'équilibre est donné par la formule (1) de l'annexe.

Dans cette formule (1), V représente la tension de commande, W représente la longueur de la piste HF, b-a représente la largeur de cette piste (voir figures 8 et 10), s représente la distance séparant les pistes au repos (c'est-à-dire sensiblement l'entrefer au centre), y représente la constante élastique de torsion de la membrane et $\in_0$ représente la permittivité du vide.

Par ailleurs, la valeur de la capacité qui existe entre les pistes haute fréquence qui se correspondent peut être calculée en fonction de l'angle φ de la membrane, de la distance s entre pistes au repos, et de la longueur desdites pistes. La formule permettant de calculer cette valeur de la capacité est donnée sous la référence (2) dans l'annexe.

On peut démontrer que la formule (1) donnant l'angle d'équilibre de la structure peut être simplifiée. Cette simplification est donnée dans l'annexe par la formule (3). On peut également déterminer la fréquence de résonance de la structure. Pour ce faire, on part de l'équation fondamentale de la dynamique, appliquée à la rotation (formule (4) de l'annexe). Dans cette équation, I représente le moment d'inertie de la membrane, α représente le coefficient d'amortissement, β représente l'effet du frottement de l'air sur la membrane, $M_E$ représente le moment de la force électrostatique qui est une fonction non linéaire de l'angle de rotation φ, et $M_T$ représente le moment du couple de torsion, qui est sensiblement équivalent à γφ.

La formule (4) peut être linéarisée si l'on considère que les angles de rotation sont petits, ce qui revient à dire que le moment de la force électrostatique $M_E$ varie peu de la valeur qui est la sienne pour un angle de rotation nul (φ=0). On déduit de cette linéarisation la fréquence de résonance $f_r$ de la structure, ainsi qu'un coefficient de qualité Q. Les expressions de ces deux paramètres sont données par les formules (5) et (6) de l'annexe.

On peut exprimer de façon approchée la fréquence de résonance $f_r$ en fonction des grandeurs géométriques du système. Cette approximation est donnée par la formule (7) de l'annexe, dans Laquelle la variable t représente l'épaisseur de la membrane.

L'évaluation du coefficient d'amortissement α peut être effectuée par une étude des frottements de l'air sur la membrane 350. Cette évaluation peut être simplifiée si l'on réalise dans la membrane des trous traversants 387 de dimensions choisies, du type de ceux illustrés sur la figure 9A. De tels trous (ou ouvertures) permettent une meilleure évacuation de l'air, ainsi qu'une réduction des forces surfaciques générées par les flux d'air qui circulent à l'intérieur de la structure.

A titre d'exemple de réalisation, non limitatif, la structure pourra présenter des dimensions dont les ordres de grandeur sont donnés ci-après :

- longueur de la membrane : quelques milliers de micromètres;
- largeur totale de la membrane : de l'ordre du millier de micromètres;
- épaisseur de la membrane (t) : de l'ordre de la dizaine de micromètres;
- distance entre pistes au repos (entrefer s) : de l'ordre de quelques micromètres;
- longueur des bras axiaux de torsion : de l'ordre de quelques centaines de micromètres;
- largeur des bras axiaux de torsion : de l'ordre de la centaine de micromètres;
- longueur des pistes haute fréquence (W) : de l'ordre du millier de micromètres; et
- largeur des pistes haute fréquence (b-a) : de l'ordre de quelques centaines de micromètres.

En ce qui concerne plus particulièrement les dimensions des pistes conductrices, et notamment celles haute fréquence, on pourra utiliser la relation empirique donnée par l'équation (8) de l'annexe pour déterminer leur longueur L en fonction de la fréquence HF.

La distance s (ou entrefer), qui sépare sensiblement les pistes minces portées par la membrane 350 et par le support 354, est de préférence fixée par la hauteur (ou profondeur) d'une cavité 388 formée dans le support 354 (voir figure 6). Bien entendu, on pourrait procéder différemment.

Cette structure peut être réalisée à l'aide de matériaux en verre et en silicium. Plus précisément, il est particulièrement avantageux de réaliser le support 354 en verre, et la membrane 350 en silicium.

La membrane 350 fait partie du support 351 qui est de préférence constitué d'un empilement de couches comportant une couche d'oxyde de silicium $SiO_2$ 389 intercalée entre une couche inférieure épaisse 390 en silicium et une couche supérieure mince 391 également en silicium et dans laquelle se trouve formée la membrane 350.

Avantageusement, on prévoit également dans cet empilement, en dessous de la couche inférieure épaisse de silicium 390, une couche d'isolant 392. Cela permet d'utiliser directement des substrats connus de l'homme du métier sous l'acronyme SOI (pour "Silicon On Insulator"). A titre d'exemple, la couche. mince supérieure de silicium, dans laquelle se trouve formée la membrane 350, présente une épaisseur de l'ordre de la dizaine de micromètres, la couche d'oxyde de silicium 389 présente une épaisseur de l'ordre de quelques micromètres, et la couche inférieure épaisse de silicium 390 présente une épaisseur de quelques centaines de micromètres.

Les substrats 351 et 354 sont solidarisés l'un à l'autre après réalisation de la membrane 350. Ce soudage peut être effectué par toute technique connue de l'homme du métier, par exemple par collage.

De façon préférentielle, la membrane 350 est réalisée par une technique de gravure par plasma bien connue de l'homme du métier, ladite gravure s'effectuant par le côté opposé à la couche 391 contenant la membrane, c'est-à-dire du côté de la couche d'isolant 392 (ou de la couche 390 de silicium lorsque la structure ne comprend pas de couche d'isolant).

Par ailleurs, la cavité 388 qui permet de gérer la distance s entre pistes est formée, de préférence par gravure chimique du support 354 en verre.

Par ailleurs, et de préférence, dans le but de protéger les pistes, on effectue une passivation de la face supérieure 353 du support 354 en verre après implantation des pistes 369 et 370, et avant solidarisation du support 354 au support 351.

Les matériaux constituant les pistes et les plots de contact (ou électrodes) sont choisis de manière à optimiser la propagation des signaux et la qualité des contacts entre certaines pistes et les plots ou électrodes.

Comme indiqué précédemment, la structure qui vient d'être décrite convient parfaitement à la réalisation de composants tout intégrés de très petites dimensions, et notamment à la réalisation de multiplieurs pour translateur de fréquence du type de celui illustré sur la figure 11.

Les avantages des montages proposés sont les suivants :

- très faible consommation, typiquement de l'ordre de 10 µA, car tous les éléments à capacité variable d'un même couple sont polarisés en inverse. On sait qu'une faible consommation est très importante pour tout type d'équipement portable, notamment;

- très bonne réjection des fréquences parasites, typiquement inférieure à -30 dB, du fait que la fonction multiplication est très proche de l'idéal;

- toutes les fréquences constituant un signal donné sont simultanément translatées de la même quantité, d'où la qualification de large bande et même très large bande du translateur.

L'invention ne se limite aux modes de réalisation décrits en référence aux figures, mais elle englobe toutes les variantes que l'homme de l'art pourra envisager dans le cadre des revendications ci-après.

Ainsi, les types respectifs des différents modules de déphasage pourront varier selon les applications, et notamment selon les fréquences utilisées. Il est clair que pour les applications en large bande, ou très large bande, on utilisera des déphaseurs large ou très large bande, comme par exemple les cellules ou réseaux à différence de phase précités. Pour les applications en bande étroite, on utilisera, de préférence, en tant que déphaseurs, des lignes à retard, formées par exemple à l'aide de câbles coaxiaux, comme décrit précédemment.

De même, le type des multiplieurs pourra varier pourvu qu'ils comprennent chacun un couple d'éléments à capacité variable de façon commandée, conjointe et en sens inverse, montés en parallèle.

**ANNEXE**

$$(1) \qquad \Phi = \frac{\varepsilon_0 V^2 W(b^2-a^2/4s^2)}{\gamma-\varepsilon_0 V^2 W(b^3-a^3/3s^3)}$$

$$(2) \qquad C=\frac{\varepsilon_0 W}{\phi}\ln(\frac{s-a\phi}{s-b\phi})$$

$$(3) \qquad \phi \propto \frac{V^2 W b^2}{\gamma s^2}$$

$$(4) \qquad I\frac{d^2\phi}{dt^2} = M_E - M_T - \alpha\frac{d\phi}{dt} - \beta\phi$$

$$(5) \qquad f_r = \frac{1}{2\pi} \sqrt{\frac{\gamma}{I}}$$

$$(6) \qquad Q = \frac{1}{\alpha} \sqrt{\gamma I}$$

$$(7) \qquad f_r \propto \frac{I}{2\pi} \sqrt{\frac{\gamma}{Wtb^3}}$$

$$(8) \qquad f_{max}\,(MHz) = \frac{2500}{L^2(cm)}$$

**Revendications**

1. Dispositif électronique à effet fréquentiel, du type comprenant deux multiplieurs (31,32) propres à recevoir un même signal de haute fréquence sur des premières entrées en quadrature l'une par rapport à l'autre, et un même signal de basse fréquence sur des secondes entrées également en quadrature l'une par rapport à l'autre, ainsi qu'un sommateur (90) des sorties de ces multiplieurs,
   **caractérisé en ce que** chacun des multiplieurs comprend un couple d'éléments ((312,313);(322,323); (358,359a,36-9a,357,359b,369b)) à capacité variable de façon commandée, conjointe et en sens inverse, montés en parallèle, et **en ce que** les sorties respectives des deux éléments de chaque couple sont combinées additivement, compte-tenu de leur opposition de phase, pour former les sorties des deux multiplieurs (31,32).

2. Dispositif selon la revendication 1, **caractérisé en ce que** chaque élément (312,313,322,323) d'un couple est défini par un varactor, les deux varactors d'un couple étant montés en parallèle à partir d'un point commun et polarisés en inverse.

3. Dispositif selon la revendication 2, **caractérisé en ce que** la première et la seconde entrée de chaque multiplieur arrivent sur ledit point commun (Mi) des deux varactors, par des liaisons séparées à découplage.

4. Dispositif selon l'une des revendications précédentes, **caractérisé en ce que** chaque multiplieur comprend, entre chaque varactor et son point commun, une inductance (L).

5. Dispositif selon la revendication 1, **caractérisé en ce que** chaque couple d'éléments est défini par :

   - des premiers moyens support (354) portant sur une face (353):

     * deux pistes conductrices haute fréquence (369a et b) sensiblement identiques, placées de façon symétrique de part et d'autre d'un plan de symétrie (P), et présentant chacune une sortie formant sortie du multiplieur, et
     * deux pistes conductrices basse fréquence (370a et b) sensiblement identiques alimentées séparément par la seconde entrée et placées de façon symétrique de part et d'autre dudit plan de symétrie (P);

   - des seconds moyens support (351) dans une partie (391) desquels se trouve suspendue à rotation autour d'un axe (I), par le biais de bras axiaux (355) opposés, une membrane (350) subdivisée, de part et d'autre d'un plan de symétrie (P) comprenant ledit axe (I), en deux demi-parties (357,358) sensiblement identiques, ladite membrane portant sur une face (352) :

     * deux pistes conductrices hyperfréquence (359a et b) sensiblement identiques, présentant chacune une extrémité reliée à la première entrée, et placées de façon symétrique de part et d'autre dudit plan de symétrie (P), et
     * deux pistes conductrices basse fréquence (360a et b) sensiblement identiques présentant chacune une extrémité reliée à la masse et placées dé façon symétrique de part et d'autre dudit plan de symétrie (P);

- lesdits seconds moyens support (351) étant solidarisés aux premiers moyens support (354) de sorte que les plans de symétrie de la membrane et des premiers moyens support soient sensiblement confondus et que les pistes haute fréquence, respectivement basse fréquence, des premiers moyens support soient superposées aux pistes haute fréquence, respectivement basse fréquence, des seconds moyens support;

  * une demi-membrane (357;358) munie de sa piste HF et de sa piste BF, d'une part, et la piste HF et la piste BF correspondantes portées par lesdits premiers moyens support (354) constituant ainsi un élément de couple.

6. Dispositif selon la revendication 5, **caractérisé en ce que** les pistes haute fréquence et basse fréquence sont parallèles entre elles, lesdites pistes haute fréquence encadrant les pistes basse fréquence.

7. Dispositif selon la revendication 5, **caractérisé en ce que** les pistes haute fréquence et basse fréquence sont parallèles entre elles, lesdites pistes basse fréquence encadrant les pistes haute fréquence.

8. Dispositif selon l'une des revendications 5 à 7, **caractérisé en ce que** les premiers moyens support (354) comprennent une cavité (388) de profondeur choisie dont le fond définit la face (353) portant les pistes conductrices haute fréquence (369a et b) et basse fréquence (370a et b).

9. Dispositif selon l'une des revendications 5 à 8, **caractérisé en ce que** les pistes haute fréquence et basse fréquence d'au moins les premiers moyens support (354) sont revêtues d'une couche très mince de passivation.

10. Dispositif selon l'une des revendications 5 à 9, **caractérisé en ce que** la membrane (350) comporte au moins un trou traversant (387) de dimensions choisies.

11. Dispositif selon l'une des revendications 5 à 10, **caractérisé en ce que** la membrane (350) est formée par gravure desdits seconds moyens support (351).

12. Dispositif selon l'une des revendications 5 à 11, **caractérisé en ce que** les premiers moyens support (354) sont formés d'un pavé en verre et les seconds moyens support (351) sont formés d'un empilement constitué d'une couche d'oxyde de Silicium ($SiO_2$) (389) intercalée entre un substrat inférieur en Silicium (390) et une couche supérieure en Silicium (391), ladite membrane (350) étant formée dans ladite couche supérieure en Silicium (391).

13. Dispositif selon la revendication 12, **caractérisé en ce que** ladite couche inférieure en Silicium (390) est placée sur un matériau isolant (392).

14. Dispositif selon l'une des revendications 1 à 13, **caractérisé en ce que** les déphasages en haute fréquence sont réalisés par des lignes à retard (11,81,82), en particulier en câble coaxial.

15. Dispositif selon l'une des revendications 5 à 14, **caractérisé en ce que** les déphasages en haute fréquence sont réalisés par des lignes à retard (11,81,82), en particulier en technologie de ligne imprimée sur substrat.

16. Dispositif selon l'une des revendications 1 à 15, **caractérisé en ce que** les déphasages en basse fréquence sont réalisés par une ou plusieurs cellules de type "R-C" (410,411) formant différentiateur sur une voie, et une ou plusieurs cellules de type "C-R" (211,212) formant intégrateur sur l'autre voie, l'ensemble étant agencé pour fournir la quadrature de phase d'une voie à l'autre.

17. Dispositif selon l'une des revendications 1 à 16, **caractérisé en ce que** les déphasages sont réalisés à l'aide de réseaux à différence de phase.

18. Dispositif selon l'une des revendications 3 et 5 à 17, **caractérisé en ce que** lesdites liaisons séparées à découplage sont rapportées à une tension de référence de la polarisation.

**Patentansprüche**

1. Elektronische Vorrichtung mit Frequenzeinwirkung, enthaltend zwei Multiziplierer (31, 32), die dazu eingerichtet sind, an ersten Eingängen ein gleiches Hochfrequenzsignal unter einer gegenseitigen Phasenverschiebung von 90° aufzunehmen und an zweiten Eingängen ein gleiches Niederfrequenzsignal ebenfalls unter einer gegenseitigen Phasenverschiebung von 90° aufzunehmen, sowie einen Summierer (90) für die Ausgänge dieser Multiplizierer,

**dadurch gekennzeichnet, daß** jeder der Multiplizierer ein Paar Elemente ((312, 313); (322, 223); (358, 359a, 369a, 357, 359b, 369 b)) enthält, die eine gemeinsam und gegensinnig gesteuert variable Kapazität aufweisen und die parallelgeschaltet sind, und daß die jeweiligen Ausgänge der zwei Elemente jedes Paares in Anbetracht ihrer entgegengesetzten Phasenlage additiv zusammengefaßt sind, um die Ausgänge der zwei Multiplizierer (31, 32) zu bilden.

2. Vorrichtung nach Anspruch 1, **dadurch gekennzeichnet, daß** jedes Element (312, 313, 322, 323) eines Paares von einem Varaktor gebildet ist, wobei die zwei Varaktoren eines Paares von einem gemeinsamen Punkt ausgehend parallel und entgegengesetzt polarisiert angeschlossen sind.

3. Vorrichtung nach Anspruch 2, **dadurch gekennzeichnet, daß** der erste und der zweite Eingang jedes Multiplizierers an dem gemeinsamen Punkt (Mi) der zwei Varaktoren über getrennte Entkopplungsverbindungsglieder angeschlossen sind.

4. Vorrichtung nach einem der vorhergehenden Ansprüche, **dadurch gekennzeichnet, daß** jeder Multiplizierer zwischen jedem Varaktor und seinem gemeinsamen Punkt eine Induktanz (L) enthält.

5. Vorrichtung nach Anspruch 1, **dadurch gekennzeichnet, daß** jedes Elementepaar gebildet ist von:

- einem ersten Träger (354), der auf einer Seite (353) aufweist:

  zwei im wesentlichen identische Hochfrequenzleiterbahnen (369a und b), die bezüglich einer Symmetrieebene (P) symmetrisch angeordnet sind und jeweils einen Ausgang haben, der den Ausgang des Multiplizierers bildet, und

  zwei im wesentlichen identische Niederfrequenzleiterbahnen (370a und b), die getrennt von dem zweiten Eingang versorgt sind und die in Bezug auf die genannte Symmetrieebene (P) symmetrisch zueinander angeordnet sind;

- einen zweiten Träger (351), in dem in einem Abschnitt (391) desselben an quer verlaufenden, sich axial gegenüberstehenden Armen (355) eine Membran (350) um eine Achse (I) drehbar aufgehängt ist, wobei die Membran beiderseits der Symmetrieebene (P), die die Achse (I) einschließt, in zwei im wesentlichen gleiche Hälften (357, 358) unterteilt ist und auf einer Seite (352) trägt:

  zwei einander im wesentlichen identische Höchstfrequenzleiterbahnen (359a und b), die jeweils ein Ende haben, das mit dem ersten Eingang verbunden ist, und die symmetrisch in Bezug auf die genannte Symmetrieebene (P) angeordnet sind, und

  zwei einander im wesentlichen identische Niederfrequenzleiterbahnen (360a und b), die jeweils ein Ende haben, das mit Masse verbunden ist, und die symmetrisch in Bezug auf die Symmetrieebene (P) angeordnet sind;

- wobei der zweite Träger (351) mit dem ersten Träger (354) derart verbunden ist, daß die Symmetrieebenen der Membran und des ersten Trägers im wesentlichen zusammenfallen und die Hochfrequenzleiterbahnen bzw. die Niederfrequenzleiterbahnen des ersten Trägers über den Hochfrequenzleiterbahnen bzw. den Niederfrequenzleiterbahnen des zweiten Trägers liegen;

wobei eine Halbmembran (357; 358), die mit ihrer Hochfrequenzleiterbahn und ihrer Niederfrequenzleiterbahn versehen ist, einerseits und die entsprechende Hochfrequenzleiterbahn und Niederfrequenzleiterbahn auf dem ersten Träger (354) auf diese Weise ein Paarelement bilden.

6. Vorrichtung nach Anspruch 5, **dadurch gekennzeichnet, daß** die Hoch- und Niederfrequenzleiterbahnen zueinander parallel sind, wobei die Hochfrequenzleiterbahnen die Niederfrequenzleiterbahnen einrahmen.

7. Vorrichtung nach Anspruch 5, **dadurch gekennzeichnet, daß** die Hoch- und Niederfrequenzleiterbahnen zueinander parallel sind, wobei die Niederfrequenzleiterbahnen die Hochfrequenzleiterbahnen einrahmen.

8.  Vorrichtung nach einem der Ansprüche 5 bis 7, **dadurch gekennzeichnet, daß** der erste Träger (354) einen Hohlraum (388) vorbestimmter Tiefe aufweist, dessen Boden die Seite (353) bildet, die die Hochfrequenzleiterbahnen (369a und b) und Niederfrequenzleiterbahnen (370a und b) trägt.

9.  Vorrichtung nach einem der Ansprüche 5 bis 8, **dadurch gekennzeichnet, daß** die Hoch- und Niederfrequenzleiterbahnen wenigstens des ersten Trägers (354) von einer sehr dünnen Passivierungsschicht bedeckt sind.

10. Vorrichtung nach einem der Ansprüche 5 bis 9, **dadurch gekennzeichnet, daß** die Membranen (350) wenigstens ein Durchgangsloch (387) vorgewählter Abmessungen aufweist.

11. Vorrichtung nach einem der Ansprüche 5 bis 10, **dadurch gekennzeichnet, daß** die Membranen (350) durch Ätzung des zweiten Trägers (351) ausgebildet ist.

12. Vorrichtung nach einem der Ansprüche 5 bis 11, **dadurch gekennzeichnet, daß** der erste Träger (354) aus einem Glasklotz gebildet ist und der zweite Träger (351) aus einem Stapel gebildet ist, der aus einer Siliciumdioxid-(SiO$_2$-) Schicht (389), die zwischen einem unteren Siliciumsubstrat (390) und einer oberen Siliciumschicht (391) angeordnet ist, besteht, wobei die Membranen (350) in der oberen Siliciumschicht (391) ausgebildet ist.

13. Vorrichtung nach Anspruch 12, **dadurch gekennzeichnet, daß** die untere Siliciumschicht (390) auf einem isolierenden Material (392) angeordnet ist.

14. Vorrichtung nach einem der Ansprüche 1 bis 13, **dadurch gekennzeichnet, daß** die Phasenverschiebungen im Hochfrequenzbereich durch Verzögerungsleitungen (11, 81, 82) insbesondere in Koaxialkabeltechnik, realisiert sind.

15. Vorrichtung nach einem der Ansprüche 5 bis 14, **dadurch gekennzeichnet, daß** die Phasenverschiebungen im Hochfrequenzbereich durch Verzögerungsleitungen (11, 81, 82) insbesondere in Leitertechnologie auf Druckschaltkarte realisiert sind.

16. Vorrichtung nah einem der Ansprüche 1 bis 15, **dadurch gekennzeichnet, daß** die Phasenverschiebungen im Niederfrequenzbereich im einen Zweig durch ein oder mehrere "R-C"-Glieder (410, 411) realisiert sind, die einen Differenzierer bilden, und im anderen Zweig durch ein oder mehrere "C-R"-Glieder (211, 212), die einen Integrierer bilden, wobei die Anordnung derart gestaltet ist, daß zwischen den beiden Zweigen eine Phasenverschiebung von 90° erzielt ist.

17. Vorrichtung nach einem der Ansprüche 1 bis 16, **dadurch gekennzeichnet, daß** die Phasenverschiebungen mit Hilfe von Phasendifferenznetzen realisiert sind.

18. Vorrichtung nach einem der Ansprüche 3 und 5 bis 17, **dadurch gekennzeichnet, daß** die gesonderten Entkopplungsglieder auf eine Polarisationsbezugsspannung berechnet sind.

**Claims**

1.  Electronic device exhibiting a frequency effect, of the type comprising two multipliers (31, 32) suitable for receiving the same high-frequency signal on first inputs, in quadrature with respect to each other, and the same low-frequency signal on second inputs, also in quadrature with respect to each other, together with a summer (90) for the outputs of these multipliers,
    **characterized in that** each of the multipliers comprises a pair of elements ((312, 313); (322, 323); (358, 359a, 369a, 357, 359b, 369b)) having a capacitance that can be varied in a controlled and joint manner and in opposite directions, these being connected in parallel, and **in that** the respective outputs of the two elements of each pair are combined additively, taking into account their phase opposition, in order to form the outputs of the two multipliers (31, 32).

2.  Device according to Claim 1, **characterized in that** each element (312, 313, 322, 323) of a pair is defined by a varactor, the two varactors of a pair being connected in parallel from a common point and inversely biased.

3. Device according to Claim 2, **characterized in that** the first input and the second input of each multiplier reach the said common point (Mi) of the two varactors via separate decoupling links.

4. Device according to one of the preceding claims, **characterized in that** each multiplier includes, between each varactor and its common point, an inductor (L).

5. Device according to Claim 1, **characterized in that** each pair of elements is defined by:

- first support means (354) bearing, on a face (353):

  * two substantially identical high-frequency conducting tracks (369a and b) placed symmetrically on either side of a plane of symmetry (P) and each having an output forming the output of the multiplier and
  * two substantially identical low-frequency conducting tracks (370a and b) supplied separately via the second input and placed symmetrically on either side of the said plane of symmetry (P);

- second support means (351) in a portion (391) of which a diaphragm (350) is suspended so as to rotate about an axis (I) by means of two opposed axial arms (355), which diaphragm (350) is subdivided, on either side of a plane of symmetry (P) within which the said axis (I) lies, into two substantially identical half-portions (357, 358), the said diaphragm carrying, on a face (352):

  * two substantially identical high-frequency conducting tracks (359a and b), each having an end connected to the first input, and placed symmetrically on either side of the said plane of symmetry (P) and
  * two substantially identical low-frequency conducting tracks (360a and b), each having one end connected to the earth, and placed symmetrically on either side of the said plane of symmetry (P);

- the said second support means (351) being fastened to the first support means (354) so that the planes of symmetry of the diaphragm and of the first support means are substantially coincident and the high-frequency tracks and low-frequency tracks respectively of the first support means are superimposed on the high-frequency tracks and low-frequency tracks respectively of the second support means;

  * a half-diaphragm (357; 358), provided with its HF track and with its LF track, on the one hand, and the corresponding HF track and the corresponding LF track carried by the said first support means (354) thus constituting an element of a pair.

6. Device according to Claim 5, **characterized in that** the high-frequency and low-frequency tracks are mutually parallel, the said high-frequency tracks flanking the low-frequency tracks.

7. Device according to Claim 5, **characterized in that** the high-frequency and low-frequency tracks are mutually parallel, the said low-frequency tracks flanking the high-frequency tracks.

8. Device according to one of Claims 5 to 7, **characterized in that** the first support means (354) include a cavity (388) of chosen depth, the bottom of which defines the face (353) bearing the high-frequency conducting tracks (369a and b) and low-frequency conducting tracks (370a and b).

9. Device according to one of Claims 5 to 8, **characterized in that** the high-frequency and low-frequency tracks of at least the first support means (354) are coated with a very thin passivation layer.

10. Device according to one of Claims 5 to 9, **characterized in that** the diaphragm (350) has at least one through-hole (387) of chosen dimensions.

11. Device according to one of Claims 5 to 10, **characterized in that** the diaphragm (350) is formed by etching the said second support means (351).

12. Device according to one of Claims 5 to 11, **characterized in that** the first support means (354) are formed from a glass tile and the second support means (351) are formed from a stack consisting of a layer of silicon oxide ($SiO_2$) (389) sandwiched between a lower silicon layer (390) and an upper silicon layer (391), the said diaphragm (350) being formed in the said upper silicon layer (391).

**13.** Device according to Claim 12, **characterized in that** the said lower silicon layer (390) is placed on an insulating material (392).

**14.** Device according to one of Claims 1 to 13, **characterized in that** the high-frequency phase shifts are produced by delay lines (11, 81, 82), particularly in a coaxial cable.

**15.** Device according to one of Claims 5 to 14, **characterized in that** the high-frequency phase shifts are produced by delay lines (11, 81, 82), particularly in printed-line-on-substrate technology.

**16.** Device according to one of Claims 1 to 15, **characterized in that** the low-frequency phase shifts are produced by one or more cells of the "R-C" type (410, 411), forming a differentiator in one channel, and one or more cells of the "C-R" type (211, 212), forming an integrator in the other channel, the assembly being designed to deliver the phase quadrature from one channel to the other.

**17.** Device according to one of Claims 1 to 16, **characterized in that** the phase shifts are produced using phase-difference networks.

**18.** Device according to one of Claims 3 and 5 to 17, **characterized in that** the said separate decoupling links are attached to a bias reference voltage.

EP 0 921 633 B1

FIG.1

FIG.2

FIG.3

FIG.4

18

550

351

392

355

390

350

389

391

355

354

FIG.5

FIG.6

FIG.7

FIG.10

FIG.8

FIG.9A

FIG.9B

FIG.11